# NEUE EUROPÄISCHE PATENTSCHRIFT

(11) **EP 0 944 480 B2**
(45) Veröffentlichungstag und Bekanntmachung des Hinweises auf die Entscheidung über den Einspruch: **15.11.2006**
(45) Hinweis auf die Patenterteilung: 27.08.2003
(21) Anmeldenummer: 98950024.4
(22) Anmeldetag: 10.09.1998
(51) Int. Cl.: B42D 15/10, D21H 21/28, C23C 14/02, C23C 14/20

(54) **SICHERHEITSELEMENT UND VERFAHREN ZU SEINER HERSTELLUNG**
SECURITY ELEMENT AND METHOD FOR PRODUCING SAME
ELEMENT DE SECURITE ET SON PROCEDE DE PRODUCTION

(30) Priorität: 10.10.1997 DE 19744953
(43) Veröffentlichungstag der Anmeldung: 29.09.1999
(73) Patentinhaber: Giesecke & Devrient GmbH, 81677 München (DE)
(72) Erfinder: KAULE, Wittich, D-82275 Emmering (DE); GRAUVOGL, Gregor, D-81479 München (DE); SCHÜTZMANN, Jürgen, D-85276 Pfaffenhofen (DE); KRETSCHMAR, Friedrich, D-81929 München (DE)
(74) Vertreter: Höhfeld, Jochen
(86) Internationale Anmeldenummer: PCT/EP1998/005787
(87) Internationale Veröffentlichungsnummer: WO 1999/019152

(56) Entgegenhaltungen:
- EP-A- 0 987 599
- WO-A-94/18003
- WO-A-96/07770
- CH-A- 678 835
- DE-A- 2 800 635
- DE-A- 3 308 831
- DE-A- 4 039 352
- DE-A- 4 130 896
- DE-A- 4 344 553
- DE-A- 19 529 171
- JP-A- 9 006 219
- US-A- 5 130 192
- US-A- 5 361 172
- US-A- 5 589 280
- W. Meckbach: "Preparation of Unbacked Cadmium Foils of Approximately 50 µg/cm²", Rev. Sci. Instr. 34, p. 188, 1963
- L. Holland: "Vacuum Deposition of Thin Films", Chapman and Hall Ltd., Hochschule Linz, Institut für Physik, 1970

## Beschreibung

Die Erfindung betrifft ein Sicherheitselement, welches wenigstens eine vernetzbare Kunststoffschicht sowie eine spiegelnd reflektierende Metallschicht aufweist. Die Erfindung betrifft ferner ein Folienmaterial sowie ein Verfahren zur Herstellung dieses Folienmaterials.

Optisch variable Elemente, wie Hologramme, Beugungsgitter etc. werden aufgrund ihrer mit dem Betrachtungswinkel variierenden optischen Eigenschaften seit langem als Fälschungs- bzw. Kopierschutzelemente verwendet. Für die Massenherstellung derartiger Elemente ist es üblich, sogenannte "Master" herzustellen, welche die jeweiligen Phaseninformationen in Form einer räumlichen Reliefstruktur aufweisen. Ausgehend von diesem Master werden durch Vervielfältigung sogenannte "Prägestempel" erzeugt, mit deren Hilfe die benötigten Beugungsstrukturen in großer Stückzahl geprägt werden können. Derartige Prägehologramme werden üblicherweise als Mehrschichtelemente auf einem separaten Träger vorbereitet und mittels einer Klebstoffschicht auf den endgültigen, gegen Verfälschung zu schützenden Gegenstand, wie z.B. Dokumente, Pässe, Kreditkarten, CDs etc. übertragen. Die Trägerschicht kann nach dem Verkleben mit dem zu schützenden Gegenstand vom Schichtaufbau des Hologramms abgezogen werden.

Das auf das Trägermaterial aufgebrachte Mehrschichtelement kann z.B. nach dem aus der US-A-4,758,296 bekannten Verfahren hergestellt werden. Hierwird eine auf Rollen umlaufende, bahnförmige Prägematrize mit einem flüssigem Harz versehen und mit einem Kunststoffträgermaterial in Kontakt gebracht. Gleichzeitig wird das flüssige Harz mittels UV- oder Elektronenstrahl gehärtet. In einem weiteren Schritt wird die Reliefstruktur mit einer dünnen Metallschicht versehen, so dass das Hologramm in Reflexion beobachtet werden kann. Für den Transfer auf ein Sicherheitsdokument wird der Schichtaufbau schließlich mit einer Heißschmelzkleberschicht versehen, die unter Einwirkung von Wärme und Druck aktiviert wird.

Es hat sich jedoch gezeigt, dass bei der Verwendung von mit UV-Strahlen vernetzbaren Prägelakken, die Metallschicht nicht optimal auf der Prägelackschicht haftet. Bei den hohen Anforderungen, die an die Beständigkeit von Sicherheitselementen gestellt werden, ist nicht nur bei UV-gehärteten Prägelacken, sondern generell auch bei ansonstigen Lacken eine Verbesserung der Metallhaftung wünschenswert.

Aus der WO 96/07770 A1 ist eine doppelseitige Reflektorfolie bekannt, die für Wohnungs- und Automobilfenster eingesetzt wird, um langwellige Strahlung zu reflektieren und sichtbares Licht durchzulassen. Eine Seite einer Kunststofffolie wird vor dem Aufbringen der Reflektorschicht einer Plasmabehandlung unterzogen. Auf die andere unbehandelte Seite der Kunststofffolie wird eine Gleitschicht aus organischen Polymeren aufgebracht und darauf eine zweite Reflektorschicht angeordnet. Die Reflektorschichten werden aufgesputtert. Zur Verbesserung der Wellenlängenselektivität der Reflektorschicht wird eine reflektierende Metallschicht in einer Art Sandwichstruktur zwischen dielektrischen Schichten angeordnet.

In der US-A-5,130,192 werden metallisierte Polyimidfolien beschrieben ,die als Magnetband oder Substrat für gedruckte Schaltungen Verwendung finden. Auf die Oberfläche einer Polyimidfolie wird eine dünne Metallschicht aufgedampft und darauf eine weitere, dickere Metallbeschichtung aufgebracht.

Der Erfindung liegt daher die Aufgabe zugrunde, ein Sicherheitselement bzw. ein Folienmaterial sowie ein Verfahren zu seiner Herstellung vorzuschlagen, das eine Verbesserung der Haftung der Metallschicht auf Kunststoffschichten gewährleistet.

Diese Aufgabe wird durch die unabhängigen Ansprüche gelöst. Weiterbildungen sind Gegenstand der Unteransprüche.

Das Wesentliche der Erfindung liegt darin, dass zwischen der Kunststoffschicht und der Metallschicht eine oder auch mehrere anorganische Hilfsschicht/en angeordnet werden. Hierbei handelt es sich um eine dünne Schicht aus einem Element oder einer Verbindung aus Elementen der II., III. und IV. Hauptgruppe sowie der 4. bis 6. Nebengruppe des Periodensystems. Insbesondere kommen als Elemente die Metalle Ti und Cr sowie als Verbindungen Oxide der Elemente Al, Ti, Zr, Sn, Be, vorzugsweise Al₂O₃, TiO₂ oder Cr₂O₃, in Frage. Es können allerdings auch Nitride, Boride oder Carbide verwendet werden, wie z. B. TiN, WC z.B. Aber auch reine Metalllegierungen, wie NiCr, sind als Hilfsschichten zur Verbesserung der Metallhaftung auf Kunststoffen geeignet.

Wichtig bei dem erfindungsgemäßen Einsatz ist, dass die Hilfsschichten zwischen dem Betrachter und der Reflexionsschicht der reflektierenden Sicherheitselemente liegen. Die Hilfsschichten werden erfindungsgemäß so dünn gemacht, dass sie die Reflexion der Reflexionsschicht nicht behindern, d.h. die optische Dichte der Hilfsschicht ist in der Größenordnung 1 oder kleiner. Bei Metallen, wie Chrom oder wenig transparenten Verbindungen, wie TiN heißt das, dass die Schicht dünner als 10 nm, vorzugsweise in der Größenordnung von 0,5 nm bis 5 nm ist. Bei gut transparenten Materialien, wie Al₂O₃ oder TiO₂ muss die Schicht auf jeden Fall so dünn sein, dass die Hologrammprägung nichtzugeschüttet wird, also auch im Allgemeinen auch kleiner als 10 nm. Die Hilfsschicht kann aufgedampft oder gesputtert oder durch sonstige Verfahren, wie PVD (physical vapor deposition) oder CVD (chemical vapor deposition) bzw. durch photo-CVD, reaktive und plasmagestützte Beschichtungsverfahren aufgebrachtwerden.

Als Reflexionsschicht wird vorzugsweise Aluminium verwendet, weil es bei hoher Reflexion und geringem Preis sich als einziges Metall billig aufdampfen lässt. Andere Metalle, die hohe Reflexion zeigen, wie Gold oder Silber sind teuer, andere billige Metalle haben keine so hohe Reflexion wie Aluminium, können aber selbstverständlich je nach Verwendungszweck des Sicherheitselements ebenfalls zum Einsatz kommen.

Gemäß einer bevorzugten Ausführungsform wird der Schichtaufbau des erfindungsgemäßen Sicherheitselements auf einer Trägerschicht vorbereitet und anschließend das Sicherheitselement in der gewünschten Form im Transferverfahren auf den zu schützenden Gegenstand übertragen. Hierbei wird eine Kunststofffolie, wie beispielsweise Polyester in einem kontinuierlichen Prozess mit einer durch UV-Strahlung vernetzbaren Lackschicht beschichtet. In diese Lackschicht wird mit Hilfe eines Prägestempels eine optisch variable Struktur, z.B. Beugungsstrukturen in Form einer Reliefstruktur übertragen. Die Beugungsstrukturen können beispielsweise echte Hologramme oder Gitterstrukturen, wie Kinegramme, Pixelgramme etc., darstellen.

Während des Prägevorgangs wird die Lackschicht durch Einwirkung von UV-Strahlung vernetzt. Als Hilfsschicht wird schließlich eine dünne Chromschicht aufgedampft oder aufgesputtert, die eine sehr gute Haftung zu dem vernetzbaren Lack aufweist. Um die Schärfe der Prägung und damit die Brillanz des optisch variablen Sicherheitselements nicht zu beeinträchtigen, wird die Chromschicht mit einer optischen Dichte von nur 0,05 aufgebracht, was in etwa einer Schichtdikke von 1 nm entspricht. Darüber wird eine Aluminiumschicht von hoher Reflektivität mit einer optischen Dichte von 2 aufgedampft. Die für den Übertrag auf den zu schützenden Gegenstand notwendige Klebstoffschicht kann ebenfalls auf das Folienmaterial aufgebracht werden. Sie kann die Aluminiumschicht hierbei vollflächig oder nur teilweise abdecken.

Die Erfindung ist jedoch nicht auf die Verwendung von UV-härtbaren Lakken beschränkt. Es können beliebige andere Prägeschichten, wie durch UV-Licht initierbare oder durch Blaulicht härtende Lacke verwendet werden. Analoges gilt für die Klebstoffschicht. So können beispielsweise Heißschmelzkleber oder ebenfalls vernetzbare Kunststoffschichten verwendet werden.

Sofern zwischen der Metallschicht und der Klebstoffschicht ebenfalls Haftungsprobleme auftreten, kann auch zwischen diesen Schichten eine Hilfsschicht gemäß der Erfindung angeordnet werden.

Gemäß einer weiteren bevorzugten Ausführungsform wird statt der reflektierenden Chromschicht eine transparente Hilfsschicht aus Aluminiumoxid verwendet. Diese Schicht wird beispielsweise durch reaktives Sputtern auf der Kunststoffschicht abgelagert. Hierbei wird Aluminium in einer sehr dünnen Sauerstoffatmosphäre von beispielsweise 0,02 mbar gesputtert. Die Schichtdicke der Aluminiumoxidschicht beträgt anschließend einige nm.

Die Metallschicht kann zusätzlich in Form von Zeichen oder Mustern ausgeführt werden oder Aussparungen in Form von Zeichen oder Mustern aufweisen. Die Teilmetallisierung wird üblicherweise während der Herstellung des Folienmaterials erzeugt, entweder indem die Metallisierung lediglich in Teilbereichen, z.B. mit Hilfe von Masken, auf die Hilfsseicht aufgebracht wird. Andere Verfahren sehen eine vollflächige Metallisierung vor, die anschießend in den nicht erwünschten Bereichen wieder entfernt wird. Dabei kann die Hilfsschicht ebenfalls mit entfernt werden, so dass sie keinerlei Einfluss auf den optischen Eindruck des Elements ausübt. Das Gleiche gilt, wenn die Hilfsschicht zwar nicht mit entfernt wird, aber transparent ist und einen Brechungsindex aufweist, der der Prägeschicht ähnlich ist sofern die Hilfsschicht jedoch eine hohe Brechkraft oder eine Eigenfarbe besitzt, kann sie auch gezielt zur optischen Gestaltung des Elements eingesetzt werden.

Mit Hilfe des auf diese Weise hergestellten Folienmaterials können schließlich Sicherheitselemente mit beliebigen Umrisskonturen auf zu sichernde Gegenstände, wie Banknoten, Ausweiskarten, aber auch andere gegen Verfälschung zu sichernde Produkte, wie CDs, Bücher etc. aufgebracht werden.

Wie bereits erwähnt, lässt sich die Erfindung jedoch nicht nur im Falle von optisch variablen Sicherheitselementen einsetzen, sondern überall dort, wo Metalle auf Lackschichten schlecht haften. So können auch andere Sicherheitselemente, wie z.B. Sicherheitsfäden für Banknoten nach dem oben beschriebenen Verfahren mit Metallbedampfungen versehen werden, sofern hierbei Haftungsprobleme zwischen einer Metallschicht und einer direkt angrenzenden Kunststoffschicht auftreten.

Weitere Beispiele des erfindungsgemäßen Sicherheitselements werden anhand der Figuren näher erläutert. Es wird darauf hingewiesen, dass die Figuren lediglich zur Veranschaulichung dienen und keine maßstabsgetreue Darstellung zeigen.

Es zeigen:
- Fig. 1: Schichtfolge beim Transfervorgang einer Beugungsstruktur auf ein Substrat im Querschnitt,
- Fig. 2: Schichtfolge im Querschnitt beim Transfer einer Metallschicht auf ein Substrat,
- Fig. 3a,b: Querschnitt der Schichtfolge bei der Erzeugung einer Teilmetallisierung mit Hilfe des Antihaftverfahrens,
- Fig. 4a,b: Querschnitt der Schichtfolge bei der Erzeugung einer Teilmetallisierung mit Hilfe des Ätzverfahrens.

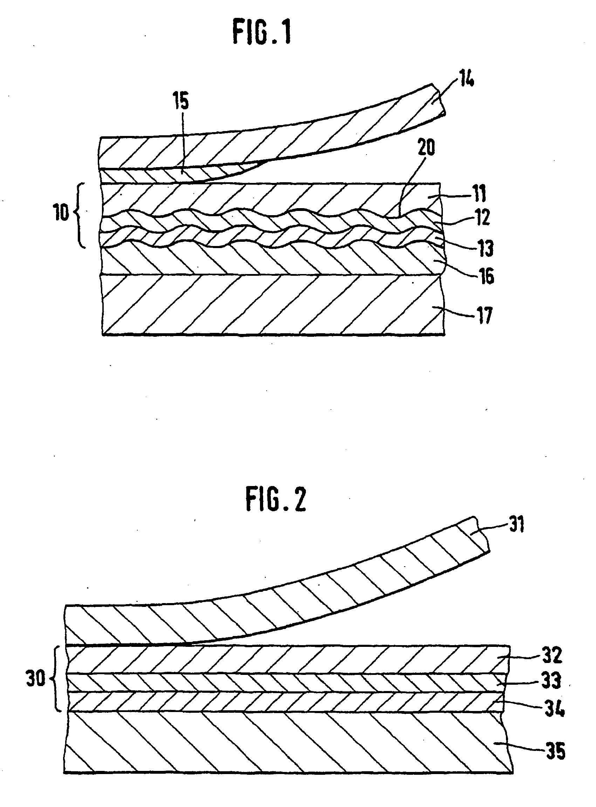

Fig. 1 zeigt die Schichtfolge beim Transfervorgang eines Sicherheitselements 10 mit einer Beugungsstruktur 20 auf ein Substrat 17. Der Schichtaufbau des zu übertragenden Sicherheitselements 10 wurde auf einer separaten Trägerfolie 14 in Endlosform vorbereitet. Die Trägerfolie 14 wurde hierbei zuerst mit einer Releaseschicht 15 versehen, die für ein gutes und definiertes Ablösen des Sicherheitselements 10 beim Übertragungsvorgang sorgt. Auf dieser Schicht wurde die Schichtfolge des Sicherheitselements 10 angeordnet. Es besteht aus einer Kunststoffschicht 11, insbesondere einer mit UV-Strahlung härtbaren Lackschicht, in welche eine Beugungsstruktur20 in Form einer Reliefstruktur eingeprägt wurde. Um die Beugungsstruktur 20 in Reflexion sichtbar zu machen, ist auf der geprägten Lackschicht 11 eine spiegelnd reflektierende Metallschicht 13, wie z.B. eine Aluminiumschicht vorgesehen. Um eine gute Haftung zwischen der Kunststoffschicht 11 und der Aluminiumschicht 13 zu gewährleisten, wird erfindungsgemäß eine Hilfsschicht 12 zwischen der Lackschicht 11 und der Metallschicht 13 angeordnet. Der Übertrag des Sicherheitselements 10 erfolgt mit Hilfe einer Kleberschicht 16, die entweder bereits auf der Trägerfolie angeordnet oder kurz vor dem Übertrag auf das Substrat 17 aufgebracht wird. Hierbei kann es sich ebenfalls um eine vernetzbare Lackschicht, wie z.B. um einen kationisch härtenden Lack, einen blaulichthärtenden Lack aber auch um einen mit einer anderen Strahlung vernetzbaren Lack handeln. Die üblicherweise eingesetzten Heißschmelzkleber, die unter Einwirkung von Wärme und Druck für eine entsprechende Haftung am Substrat sorgen, können selbstverständlich ebenfalls eingesetzt werden.

Auch hinsichtlich der Prägelackschicht 11 ist die Erfindung keinesweg auf die Verwendung UV-härtbarer Lacke beschränkt. Es können beliebige andere Lacke eingesetzt werden.

Sofern zwischen der Metallschicht 13 und der Klebstoffschicht 16 ebenfalls Haftungsprobleme auftreten, kann zwischen diesen Schichten auch eine Hilfsschicht gemäß der Erfindung vorgesehen werden.

Die Release-Schicht 15 auf der Trägerfolie 14 ist nicht obligatorisch. Ihre Verwendung und wenn ja, welche Art von Schicht eingesetzt wird, hängt von den jeweiligen Haftungsbedingungen zwischen Trägerfolie und Lackschicht ab.

Statt dem Vakuumdampfverfahren kann für das Aufbringen der reflektierenden Metallschicht, die nicht notwendigerweise aus Aluminium bestehen muss, selbstverständlich auch ein anderes Verfahren, wie z.B. Galvanisieren verwendet werden.

Unter Umständen kann es auch vorteilhaft sein, das Sicherheitselement 10 direkt auf dem Dokumentenmaterial zu erzeugen. Hierfürwird der Prägelack direkt auf das Substrat aufgebracht und dort mit der Beugungsstruktur geprägt. Nach dem Prägevorgang wird die haftvermittelnde Hilfsschicht nach einem beliebigen Verfahren möglichst dünn aufgebracht und mit der Aluminiumschicht, beispielsweise im Vakuumdampfverfahren, versehen. Gegebenenfalls können auf der Metallschicht weitere Schichten, wie eine Schutzschicht oder eine weitere Hilfsschicht zwischen Metall- und Schutzschicht, vorgesehen werden.

Fig. 2 zeigt eine Variante der Erfindung, bei welcher eine Metallschicht mittels einer Lackschicht auf ein Substrat übertragen wird. Hier wird das Sicherheitselement 30 ebenfalls auf einer Trägerfolie 31 in Endlosform vorbereitet und anschließend mit Hilfe einer Klebstoffschicht auf das Substrat 35 übertragen. Auch hier kann es notwendig sein, zwischen der Trägerfolie 31 und der zu übertragenden Metallschicht 32 eine Releaseschicht vorzusehen, die in der Figur allerdings nicht gezeigt ist. Die Trägerfolie 31 wird anschließend mit der gewünschten Metallschicht 32 vollflächig bedampft. Um die Haftung der Metallschicht 32 an der als Klebstoff wirkenden Lackschicht 34 zu verbessern, wird die Metallschicht 32 zusätzlich mit einer dünnen Hilfsschicht 33 versehen, die, wie bereits erwähnt, beispielsweise eine Chromoder Aluminiumoxidschicht sein kann. Die Lackschicht 34 kann entweder auf diese Hilfsschicht 33 oder auf das Substrat 35 aufgetragen werden. Während des Kontakts zwischen Lackschicht 34 und Substrat 35 wird die Lackschicht 34 verfestigt, so dass die Metallschicht auf dem Substrat 35 haftet. Vernetzbare Klebstoffschichten sorgen hierbei aufgrund der Irreversibilität des Vernetzungsprozesses für einen unlösbaren Verbund zwischen Substrat und der Metallschicht 32. In einem letzten Schritt kann die Trägerfolie 31 abgezogen werden.

Die Metallschicht muss nicht notwendigerweise vollflächig auf der Trägerschichtvorgesehen werden. Sie kann auch in Form von Zeichen oder Mustern aufgebracht werden oder Aussparungen in Form von Zeichen, Mustern oder dergleichen aufweisen. Sofern die Hilfsschicht nicht transparent ist, sollte diese in einem solchen Fall deckungsgleich zu der Metallschicht aufgebracht werden, um den optischen Eindruck des Sicherheitselements nicht zu stören. Für den Fall, dass die anorganische Hilfsschicht jedoch zumindest teilweise transparent ist, kann sie auch zur optischen Gestaltung des Sicherheitselements eingesetzt werden.

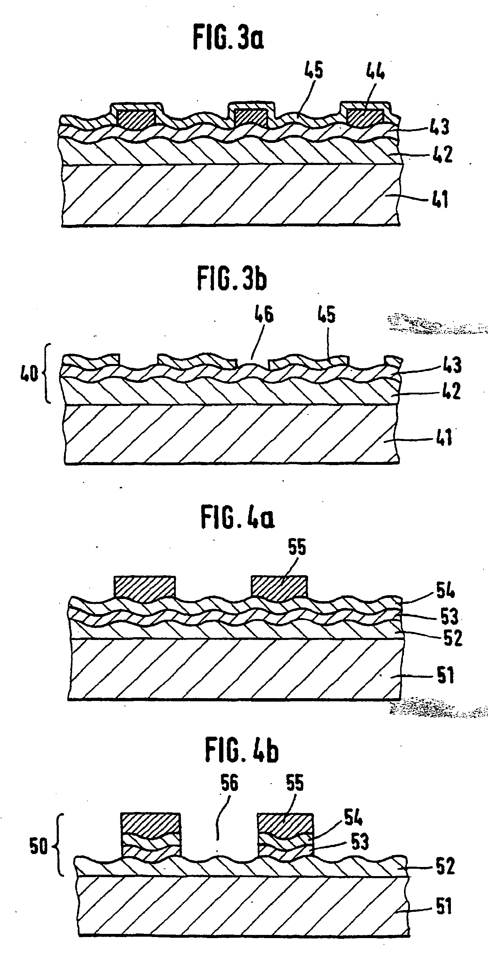

Die Fig. 3a bis 4b zeigen die Herstellung eines derartigen erfindungsgemäßen Folienmaterials, welches eine Kunststoffschicht mit geprägter Oberfläche sowie einer hierauf angeordneten teilweisen Metallisierung enthält.

Fig. 3a zeigt eine Trägerfolie 41, welche, wie bereits beschrieben, mit einer Prägelackschicht 42 versehen wurde, in welche eine Reliefstruktur, wie z.B, eine Beugungsstruktur eingeprägt wurde. Auf dieser Prägeschicht wurde erfindungsgemäß eine anorganische Hilfsschicht 43 angeordnet. Anschließend wurden die Bereiche der Hilfsschicht 43, die am fertigen Sicherheitselement 40 (Fig. 3b) metallfrei sein sollen, mit einer löslichen Druckfarbe 44 bedruckt. Anschließend wurde die gesamte Trägerfolie 41 mit einer vollflächigen Metallisierung 45 versehen. Dieser Schichtaufbau wird anschließend mit einem Lösungsmittel für die Druckfarbe 44 behandelt, so dass die Druckfarbe 44 und die im Bereich dieser Druckfarbe 44 befindliche Metallisierung 45 entfernt werden.

Fig. 3b zeigt das erfindungsgemäße Folienmaterial nach dem Lösevorgang. Die Metallisierung 45 ist hier nurmehr in Teilbereichen, die anorganische Hilfsschicht 43 dagegen nach wie vor vollflächig vorhanden. Die metallschichtfreien Bereiche 46 können die Form von Buchstaben, Mustern oder dergleichen haben, die je nach Ausführung der Hilfsschicht transparent, teilreflektierend oder teiltransparent erscheinen können. Handelt es sich bei der Hilfsschicht beispielsweise um eine Metallschicht, so erscheinen die Aussparungen aufgrund der optischen Dichte < 1 der Hilfsschicht teiltransparent. Bei der Verwendung von Oxiden dagegen ergibt sich die Teiltransparenz bzw. Teilreflexion aus deren hoch brechenden Eigenschaften, insbesondere wenn die Oxide als sogenannte "dielektrische Spiegel" ausgeführt sind. In diesem Fall ergeben sich in Reflexion und Transmission auch besondere Farbeffekte.

Gemäß einer Variante kann die lösliche Druckfarbe 44 auch unterhalb der Hilfsschicht 43 direkt auf die Prägeschicht 42 aufgedruckt werden. In diesem Fall wird nicht nur die Metallschicht 45 sondern auch die im Bereich der Druckfarbe befindliche Hilfsschicht 43 entfernt, so dass die metallschichtfreien Bereiche 46 in jedem Fall transparent erscheinen und durch die optischen Eigenschaften der Hilfsschicht 43 nicht beeinflusst werden.

Eine weitere Verfahrensvariante zur Herstellung der metallschichtfreien Bereiche wird anhand der Fig. 4a und 4b näher erläutert. Auch hier wurde die Trägerfolie 51 mit einer geprägten Kunststoffschicht 52 sowie einer anorganischen Hilfsschicht 53 und einer vollflächigen Metallisierung 54 versehen (Fig. 4a). Im Anschluss hieran wurde eine lösungsmittelresistente Druckfarbe 55 in den Bereichen der Metallisierung aufgedruckt, die anschließend im Sicherheitselement 50 verbleiben sollen. Der so vorbehandelte Folienaufbau wird anschließend einem Lösungsmittel ausgesetzt, welches die nicht abgedeckten Bereiche der Metallisierung 54 sowie der Hilfsschicht 53 entfernt, nicht jedoch die durch die Abdeckschicht 55 geschützten Teile der Metallisierung 54 und der Hilfsschicht 53.

Fig. 4b zeigt wieder das Folienmaterial mit dem fertigen Sicherheitselement 50. Die Prägeschicht 52 ist nach wie vor vollflächig vorhanden, die Hilfsschicht 53 sowie die Metallisierung 54 dagegen liegen nurmehr bereichsweise vor, so dass metallschichtfreie Teilbereiche 56 entstehen. Im gezeigten Fall ist nurmehr ein kleiner Teilbereich der Prägestruktur mit der Metallisierung 54 sowie der Hilfsschicht 53 versehen. Die Metallisierung kann dabei die Form von Zeichen oder Mustern aufweisen.

Auch in diesem Beispiel ist es selbstverständlich möglich, ein Lösungsmittel zu verwenden, welches lediglich die Metallschicht 54, nicht aber die Hilfsschicht 53 löst und damit entfernt.

Gemäß einer Variante ist es auch möglich, das Folienmaterial, nachdem die vollflächige Metallisierung aufgebracht wurde, direkt mit einer ätzenden Druckfarbe zu bedrucken, um die Metallschicht- bzw. metall- und hilfsschichtfreien Bereiche zu erzeugen.

Der auf die beschriebene Weise hergestellte Folienschichtaufbau mit einer Teilmetallisierung kann selbstverständlich anschließend mit weiteren Schichten versehen werden, wie z.B. weiteren Hilfsschichten, Klebstoffschichten oder Schutzschichten, je nach Anwendungsfall des Sicherheitselementes.

## Patentansprüche

1. Sicherheitselement, welches wenigstens eine Kunststoffschicht mit einer geprägten, optisch variablen Struktur sowie eine spiegelnd reflektierende Metallschicht aufweist, **dadurch gekennzeichnet, dass** zwischen der Kunststoffschicht und der Metallschicht eine anorganische Hilfsschicht angeordnet ist, die die Haftung zwischen der Metallschicht und der Kunststoffschicht erhöht.

2. Sicherheitselement nach Anspruch 1, **dadurch gekennzeichnet, dass** die Hilfsschicht eine optische Dichte von maximal 1 aufweist.

3. Sicherheitselement nach Anspruch 1 oder 2, **dadurch gekennzeichnet, dass** die Hilfsschicht ein Element oder eine Verbindung aus Elementen der II., III. und IV. Hauptgruppe sowie der 4. bis 6. Nebengruppe des Periodensystems ist.

4. Sicherheitselement nach wenigstens einem der Ansprüche 1 bis 3, **dadurch gekennzeichnet, dass** die Hilfsschicht aus Titan (Ti), Chrom (Cr) oder Titannitrid (TiN) besteht.

5. Sicherheitselement nach Anspruch 1 bis 3, **dadurch gekennzeichnet, dass** die Hilfsschicht ein Oxid der Elemente Aluminium (Al), Titan (Ti), Zirkonium (Zr), Zinn (Sn), Beryllium (Be), Chrom (Cr) oder Silizium (Si) ist.

6. Sicherheitselement nach Anspruch 5, **dadurch gekennzeichnet, dass** die Hilfsschicht aus Al₂O₃, TiO₂ oder Cr₂O₃ besteht.

7. Sicherheitselement nach Anspruch 1 oder 2, **dadurch gekennzeichnet, dass** die Hilfsschicht aus einer Metallverbindung oder -legierung besteht.

8. Sicherheitselement nach wenigstens einem der Ansprüche 1 bis 7, **dadurch gekennzeichnet, dass** die Kunststoffschicht eine Beugungsstruktur in Form einer Reliefstruktur aufweist.

9. Sicherheitselement nach wenigstens einem der Ansprüche 1 bis 8, **dadurch gekennzeichnet, dass** das Sicherheitselement die Form eines Fadens oder Bandes aufweist.

10. Sicherheitselement nach wenigstens einem der Ansprüche 1 bis 9, **dadurch gekennzeichnet, dass** die Kunststoffschicht eine mit UV-Strahlung vernetzbare Schicht ist.

11. Sicherheitselement nach wenigstens einem der Ansprüche 1 bis 10, **dadurch gekennzeichnet, dass** die Metallschicht nur in Teilbereichen vorgesehen ist.

12. Sicherheitselement nach wenigsten einem der Ansprüche 1 bis 11, **dadurch gekennzeichnet, dass** die Hilfsschicht deckungsgleich zur Metallschicht angeordnet ist.

13. Sicherheitselement nach wenigstens einem der Ansprüche 1 bis 12, **dadurch gekennzeichnet, dass** die Metallschicht auf der von der Kunststoffschicht abgewandten Oberfläche ebenfalls mit einer Hilfsschicht versehen ist.

14. Sicherheitsdokument, wie eine Banknote, Ausweiskarte oder dergl., **dadurch gekennzeichnet, dass** es zumindest ein Sicherheitselement gemäß wenigstens einem der Ansprüche 1 bis 13 aufweist.

15. Sicherheitsdokument nach Anspruch 14, **dadurch gekennzeichnet, dass** das Sicherheitselement auf der Oberfläche des Sicherheitsdokuments angeordnet ist.

16. Sicherheitsdokument nach Anspruch 14, **dadurch gekennzeichnet, dass** das Sicherheitselement zumindest teilweise in das Sicherheitsdokument eingebettet ist.

17. Folienmaterial für Sicherheitselemente, mit einer Kunststofffolie, auf welcher eine Kunststoffschicht mit einer geprägten, optisch variablen Struktur sowie eine spiegelnd reflektierende Metallschicht angeordnet ist, **dadurch gekennzeichnet, dass** zwischen der Kunststoffschicht und der Metallschicht eine anorganische Hilfsschicht angeordnet ist, die die Haftung zwischen der Metallschicht und der Kunstststoffschicht erhöht.

18. Verfahren zur Herstellung eines Folienmaterials für Sicherheitselemente nach Anspruch 17, **gekennzeichnet durch** folgende Schritte:
- Bereitstellen einer Kunststofffolie in Endlosform als Trägerfolie,
- Aufbringen einer Kunststoffschicht auf die Kunststofffolie,
- Aufbringen einer anorganischen Hilfsschicht auf die Kunststoffschicht,
- Aufbringen einerspiegelnd reflektierenden Metallschicht auf die anorganische Hilfsschicht durch Bedampfen, Galvanisieren oder chemisches Abscheiden.

19. Verfahren nach Anspruch 18, **dadurch gekennzeichnet, dass** auf die Metallschicht eine weitere anorganische Hilfsschicht und gegebenenfalls weitere Kunststoffschichten aufgebracht werden.

20. Verfahren nach Anspruch 18 oder 19, **dadurch gekennzeichnet, dass** zumindest die Metallschicht lediglich in Teilbereichen aufgebracht wird.

21. Verfahen nach Anspruch 20, **dadurch gekennzeichnet, dass** die Metallschicht vollflächig aufgebracht und anschließend durch Bedrucken mit einer Ätzfarbe oder bereichsweises Abdecken und Wegätzen der nicht abgedeckten Bereiche teilweise entfernt wird.

22. Verfahren nach Anspruch 20, **dadurch gekennzeichnet, dass** vor dem Aufbringen der Metallschicht bzw. vor dem Aufbringen der Hilfsschicht eine Druckfarbe in Form der metallfreien Bereiche aufgebracht wird, anschließend die Kunststofffolie vollflächig metallisiert und die Druckfarbe anschließend mit einem Lösungsmittel gelöst wird, so dass metallfreie Bereiche entstehen.

23. Verfahren nach wenigstens einem der Ansprüche 18 bis 22, **dadurch gekennzeichnet, dass** als Hilfsschicht eine Chromschicht verwendet wird, die auf die Kunststoffschicht aufgedampft oder -gesputtert oder durch sonstige PVD-, CVD- sowie plasmagestützte Beschichtungsverfahren aufgebracht wird.

24. Verfahren nach wenigstens einem der Ansprüche 18 bis 22, **dadurch gekennzeichnet, dass** als Hilfsschicht eine Aluminiumoxidschicht verwendet wird, die durch Aufsputtern einer Aluminiumschicht in Sauerstoffatmosphäre auf der Kunststoffschicht erzeugt wird.

25. Verfahren nach wenigstens einem der Ansprüche 18 bis 24, **dadurch gekennzeichnet, dass** die Hilfsschicht in einer Dicke von weniger als 10 nm, vorzugsweise von 0,5 bis 5 nm, aufgebracht wird.

26. Verfahren nach wenigstens einem der Ansprüche 18 bis 25, **dadurch gekennzeichnet, dass** als Metallschicht eine Aluminiumschicht verwendet wird, die in einer Dicke von 10 bis 40 nm erzeugt wird.

27. Verfahren nach wenigstens einem der Ansprüche 18 bis 26, **dadurch gekennzeichnet, dass** in die Kunststoffschicht vor dem Aufbringen der Hilfsschicht eine Reliefstruktur eingeprägt wird.

28. Verfahren nach wenigstens einem der Ansprüche 18 bis 27, **dadurch gekennzeichnet, dass** als Kunststoffschicht eine vernetzbare Kunststoffschicht verwendet wird.

## Claims

1. A security device having at least one plastic layer with an embossed, optically variable structure and a specularly reflecting metal layer, **characterized in that** the plastic layer and the metal layer have disposed therebetween an inorganic auxiliary layer which increases the adhesion between the metal layer and the plastic layer.

2. A security device according to claim 1, **characterized in that** the auxiliary layer has a maximum optical density of 1.

3. A security device according to claim 1 or 2, **characterized in that** the auxiliary layer is an element or a compound of elements from main groups II, III and IV and subgroups 4 to 6 of the periodic system.

4. A security device according to at least one of claims 1 to 3, **characterized in that** the auxiliary layer consists of titanium (Ti), chromium (Cr) or titanium nitride (TiN).

5. A security device according to claims 1 to 3, **characterized in that** the auxiliary layer is an oxide of the elements, aluminum (Al), titanium (Ti), zirconium (Zr), tin (Sn), beryllium (Be), chromium (Cr) or silicon (Si).

6. A security device according to claim 5, **characterized in that** the auxiliary layer consists of Al₂O₃, TiO₂ or Cr₂O₃.

7. A security device according to claim 1 or 2, **characterized in that** the auxiliary layer consists of a metal compound or metal alloy.

8. A security device according to at least one of claims 1 to 7, **characterized in that** the plastic layer has a diffraction structure in the form of a relief structure.

9. A security device according to at least one of claims 1 to 8, **characterized in that** the security device has the form of a thread or band.

10. A security device according to at least one of claims 1 to 9, **characterized in that** the plastic layer is a layer crosslinkable by UV radiation.

11. A security device according to at least one of claims 1 to 10, **characterized in that** the metal layer is provided only in partial areas.

12. A security device according to at least one of claims 1 to 11, **characterized in that** the auxiliary layer is disposed congruently to the metal layer.

13. A security device according to at least one of claims 1 to 12, **characterized in that** the metal layer is likewise provided with an auxiliary layer on the surface facing away from the plastic layer.

14. A security document, such as a bank note, ID card or the like, **characterized in that** it has at least one security device according to at least one of claims 1 to 13.

15. A security document according to claim 14, **characterized in that** the security device is disposed on the surface of the security document.

16. A security document according to claim 14, **characterized in that** the security device is embedded at least partly in the security document.

17. A foil material for security elements having a plastic foil on which a plastic layer with an embossed, optically variable structure and a specularly reflecting metal layer are disposed, **characterized in that** the plastic layer and the metal layer have disposed therebetween an inorganic auxiliary layer which increases the adhesion between the metal layer and the plastic layer.

18. A method for producing a foil material for security elements according to claim 17, **characterized by** the following steps:
providing a plastic foil in endless form as a carrier foil,
applying a plastic layer to the plastic foil,
applying an inorganic auxiliary layer to the plastic layer,
applying a specularly reflecting metal layer to the inorganic auxiliary layer by vapor deposition, galvanizing or chemical deposition.

19. A method according to claim 18, **characterized in that** a further inorganic auxiliary layer and optionally further plastic layers are applied to the metal layer.

20. A method according to claim 18 or 19, **characterized in that** at least the metal layer is applied only in partial areas.

21. A method according to claim 20, **characterized in that** the metal layer is applied all over and subsequently partly removed by being printed with an etching ink or covered in certain areas and the uncovered areas being etched away.

22. A method according to claim 20, **characterized in that** a printing ink is applied in the form of the metal-free areas before application of the metal layer or before application of the auxiliary layer, the plastic foil is then metalized all over, and the printing ink then dissolved with a solvent, resulting in metal-free areas.

23. A method according to at least one of claims 18 to 22, **characterized in that** the auxiliary layer used is a chromium layer which is vapor-deposited or sputtered on the plastic layer or applied by other PVD, CVD and plasma-enhanced coating methods.

24. A method according to at least one of claims 18 to 22, **characterized in that** the auxiliary layer used is an aluminum oxide layer which is produced on the plastic layer by sputtering an aluminum layer in an oxygen atmosphere.

25. A method according to at least one of claims 18 to 24, **characterized in that** the auxiliary layer is applied in a thickness of less than 10 nm, preferably 0.5 to 5 nm.

26. A method according to at least one of claims 18 to 25, **characterized in that** the metal layer used is an aluminum layer which is produced in a thickness of 10 to 40 nm.

27. A method according to at least one of claims 18 to 26, **characterized in that** a relief structure is embossed in the plastic layer before application of the auxiliary layer.

28. A method according to at least one of claims 18 to 27, **characterized in that** the plastic layer used is a crosslinkable plastic layer.

## Revendications

1. Élément de sécurité, qui présente au moins une couche de matière plastique ainsi qu'une couche métallique spéculaire réfléchissante, **caractérisé en ce qu'**entre la couche de matière plastique et la couche métallique est disposée une couche auxiliaire minérale qui augmente l'adhérence entre la couche métallique et la couche de matière plastique.

2. Élément de sécurité selon la revendication 1, **caractérisé en ce que** la couche auxiliaire présente une densité optique d'une valeur maximale de 1.

3. Élément de sécurité selon la revendication 1 ou 2, **caractérisé en ce que** la couche auxiliaire est un élément ou un composé d'éléments des groupes principaux II, III et IV ainsi que des groupes secondaires 4 à 6 du tableau périodique.

4. Élément de sécurité selon au moins une des revendications 1 à 3, **caractérisé en ce que** la couche auxiliaire est constituée de titane (Ti), de chrome (Cr) ou de nitrure de titane (TiN).

5. Élément de sécurité selon l'une des revendications 1 à 3, **caractérisé en ce que** la couche auxiliaire est un oxyde des éléments aluminium (Al), titane (Ti), zirconium (Zr), étain (Sn), béryllium (Be), chrome (Cr) ou silicium (Si).

6. Élément de sécurité selon la revendication 5, **caractérisé en ce que** la couche auxiliaire est constituée de Al₂O₃, TiO₂ ou Cr₂O₃.

7. Élément de sécurité selon la revendication 1 ou 2, **caractérisé en ce que** la couche auxiliaire est constituée d'un composé métallique ou d'un alliage métallique.

8. Élément de sécurité selon l'une au moins des revendications 1 à 7, **caractérisé en ce que** la couche de matière plastique présente une structure de diffraction sous la forme d'une structure en relief.

9. Élément de sécurité selon l'une au moins des revendications 1 à 8, **caractérisé en ce que** l'élément de sécurité présente la forme d'un fil ou d'une bande.

10. Élément de sécurité selon l'une au moins des revendications 1 à 9, **caractérisé en ce que** la couche de matière plastique est une couche réticulable par rayonnement UV.

11. Élément de sécurité selon l'une au moins des revendications 1 à 10, **caractérisé en ce que** la couche métallique est prévue seulement dans des zones partielles.

12. Élément de sécurité selon l'une au moins des revendications 1 à 11, **caractérisé en ce que** la couche auxiliaire est disposée en coïncidence avec la couche métallique.

13. Élément de sécurité selon l'une au moins des revendications 1 à 12, **caractérisé en ce que** la couche métallique est également pourvue d'une couche auxiliaire sur la surface opposée à la couche de matière plastique.

14. Document de sécurité, tel qu'un billet de banque, une carte d'identité ou similaires, **caractérisé en ce qu'**il présente au moins un élément de sécurité selon l'une au moins des revendications 1 à 13.

15. Document de sécurité selon la revendication 14, **caractérisé en ce que** l'élément de sécurité est disposé sur la surface du document de sécurité.

16. Document de sécurité selon la revendication 14, **caractérisé en ce que** l'élément de sécurité est incorporé au moins partiellement dans le document de sécurité.

17. Matériau en feuille pour des éléments de sécurité, avec une feuille de matière plastique sur laquelle est disposée une couche de matière plastique avec une structure estampée, optiquement variable, ainsi qu'une couche métallique spéculaire réfléchissante, **caractérisé en ce qu'**entre la couche de matière plastique et la couche métallique est disposée une couche auxiliaire minérale, qui augmente l'adhérence entre la couche métallique et la couche de matière plastique.

18. Procédé de fabrication d'un matériau en feuille pour des éléments de sécurité selon la revendication 17, **caractérisé par** les étapes suivantes :
mise à disposition d'une feuille de matière plastique sous forme continue comme feuille de support,
application d'une couche de matière plastique sur la feuille de matière plastique,
application d'une couche auxiliaire minérale sur la couche de matière plastique,
application d'une couche métallique spéculaire réfléchissante sur la couche auxiliaire minérale par métallisation sous vide titanisation, galvanisation ou dépôt chimique.

19. Procédé selon la revendication 18, **caractérisé en ce qu'**une autre couche auxiliaire minérale et, le cas échéant, d'autres couches en matière plastique, sont appliquées sur la couche métallique.

20. Procédé selon la revendication 18 ou 19, **caractérisé en ce que** la couche métallique au moins est appliquée uniquement dans des zones partielles.

21. Procédé selon la revendication 20, **caractérisé en ce que** la couche métallique est appliquée sur toute la surface et est ensuite éliminée partiellement par impression avec une encre d'attaque chimique ou par recouvrement par zones et élimination par décapage des zones non recouvertes.

22. Procédé selon la revendication 20, **caractérisé en ce qu'**avant l'application de la couche métallique ou avant l'application de la couche auxiliaire, une encre d'imprimerie est appliquée selon la forme des zones exemptes de métal, et **en ce que** la feuille de matière plastique est ensuite totalement métallisée et l'encre d'imprimerie est ensuite dissoute avec un solvant, de façon à créer des zones exemptes de métal.

23. Procédé selon l'une au moins des revendications 18 à 22, **caractérisé en ce qu'**une couche de chrome est utilisée comme couche auxiliaire, qui est appliquée sur la couche de matière plastique par métallisation sous vide ou pulvérisation ou par d'autres procédés de recouvrement par dépôt physique en phase vapeur, dépôt chimique en phase vapeur ainsi que par des procédés de recouvrement de protection à base de plasma.

24. Procédé selon l'une au moins des revendications 18 à 22, **caractérisé en ce qu'**une couche d'oxyde d'aluminium est utilisée comme couche auxiliaire, qui est produite par pulvérisation d'une couche d'aluminium dans une atmosphère d'oxygène sur la couche de matière plastique.

25. Procédé selon l'une au moins des revendications 18 à 24, **caractérisé en ce que** la couche auxiliaire est appliquée sur une épaisseur de moins de 10 nm, de préférence de 0,5 à 5 nm.

26. Procédé selon l'une au moins des revendications 18 à 25, **caractérisé en ce qu'**une couche d'aluminium est utilisée comme couche métallique, qui est produite sur une épaisseur de 10 à 40 nm.

27. Procédé selon l'une au moins des revendications 18 à 26, **caractérisé en ce qu'**une structure en relief est imprimée dans la couche de matière plastique avant l'application de la couche auxiliaire.

28. Procédé selon l'une au moins des revendications 18 à 27, **caractérisé en ce qu'**une matière plastique réticulable est utilisée comme couche de matière plastique.
